(19) **Europäisches Patentamt / European Patent Office / Office européen des brevets**

(11) **EP 1 978 565 A1**

(12) # EUROPEAN PATENT APPLICATION
published in accordance with Art. 158(3) EPC

(43) Date of publication:
**08.10.2008 Bulletin 2008/41**

(21) Application number: **06841735.1**

(22) Date of filing: **13.12.2006**

(51) Int Cl.:
*H01L 31/06* [(2006.01)]    *H01L 31/08* [(2006.01)]
*H01L 31/0352* [(2006.01)]    *H01L 31/0296* [(2006.01)]
*H01L 31/0304* [(2006.01)]

(86) International application number:
**PCT/ES2006/000683**

(87) International publication number:
**WO 2007/068775 (21.06.2007 Gazette 2007/25)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **13.12.2005 ES 200503055**

(71) Applicant: **UNIVERSIDAD POLITECNICA DE MADRID**
**28040 Madrid (ES)**

(72) Inventors:
• **LUQUE LÓPEZ, Antonio**
**E-28040 Madrid (ES)**

• **MARTÍ VEGA, Antonio**
**E-28040 Madrid (ES)**
• **TABLERO CRESPO, César**
**E-28040 Madrid (ES)**
• **ANTOLÍN FERNÁNDEZ, Elisa**
**E-28040 Madrid (ES)**

(74) Representative: **Carvajal y Urquijo, Isabel et al Clarke, Modet & Co.**
**C/Goya 11**
**28001 Madrid (ES)**

(54) **SUPPRESSION OF NON-RADIATIVE RECOMBINATION IN MATERIALS WITH DEEP CENTRES**

(57)    Procedure to obtain semiconductor materials with electronic levels close to the mid-bandgap (*deep levels*) which do not suffer from the non-radiative recombination by multiple phonon emission (MPE) associated to the existence of that kind of levels. The procedure consist in doping by any means the semiconductor with a density sufficiently high of the impurities producing the deep level, so that a Mott transition of the electron wavefunctions representing the localized states in the impurities is induced, in such a way that these wavefunctions become distributed across the whole semiconductor and are shared by all the impurities. When this happens, local charge density variations, and thus non-radiative recombination by MPE, disappear. Based on the resulting materials (semiconductors with three separate energy bands and radiative behavior (1), (2) and (3)) different optoelectronic devices can be fabricated (solar cells, photodetectors, lasers, etc.) capable of using electronic radiative transitions more efficiently.

Fig. 1

EP 1 978 565 A1

**Description**

**Technical Branch**

Energy technology (photovoltaic converters), opto-electronic technology (LEDs and lasers), telecommunications engineering and medicine (radiation sensors), laboratory instruments.

**Prior State of the Art**

It is widely known that foreign atoms of different types can be dissolved in semiconductors, often above the solubility limit. A number of techniques are also known on how to introduce intentionally these foreign atoms in the semiconductor. These *doping* techniques include pouring the impurities in the molten semiconductor prior to freeze and grow the melt as a crystal, ionic implantation or the solid state diffusion from the surface.

It is also known that the addition of certain foreign atoms produces deep levels in the energy bandgap of semiconductors, i.e. electronic states that lie far in energy from both the conduction and valence bands. In particular transition elements such as Cr, Ti, Va, etc, tend to produce deep levels in almost any semiconductor. Chalcogenides produce deep levels in silicon, etc. On the contrary some other atoms produce shallow levels, called so because the energy difference between them and one of the bands is relatively small. It is the case of P or B in Si and of Si in GaAs, for instance.

Doping with impurity species that give rise to shallow levels is common practice in semiconductor device technology. It is through this procedure that semiconductor materials acquire many of the electrical properties that will determine the performance of devices. The application of shallow level doping allows us, for instance, to set the proportion between electrons and holes, making that one kind of them becomes majority carrier in the semiconductor (*p*- or *n*-type doping) or to produce, through a sequence of two different dopings, a potential difference inside the material under equilibrium conditions (*pn*-junction). On the other hand, the optical transitions that some shallow levels make possible for electrons are also exploitable. Nonetheless, the energetic range of these transitions is very limited, since shallow levels are characterized by being close to one of the energetic bands of the semiconductor.

On the contrary, doping with deep levels has almost not been exploited to the date. Furthermore, much effort is paid to avoid the presence of the impurities that give rise to them in electronic grade semiconductors or to remove these impurities when they are present. The reason is that deep levels are a source of non-radiative recombination and it is well-known that a high non-radiative recombination entails a poor performance for the vast majority of devices (high saturation currents, drop of the light emission, etc.). One exception to this tendency to avoid deep levels appears when fast bipolar devices are sought, in which case they are added in controlled form to increase the recombination and help the stored bipolar charge to disappear quickly.

But at the same time, deep levels may be of interest for a number of applications, many of them associated to optical properties. To make use of their possibilities, it is mandatory to eliminate first the non-radiative recombination that they promote, which is possible through the procedure presented in this patent. Although deep centers do not provide to the semiconductor the electric properties that make shallow levels attractive (they are not ionized at room temperature and therefore they cannot be used to increase the carrier population), their optical properties could have a wider use than those of shallow levels.

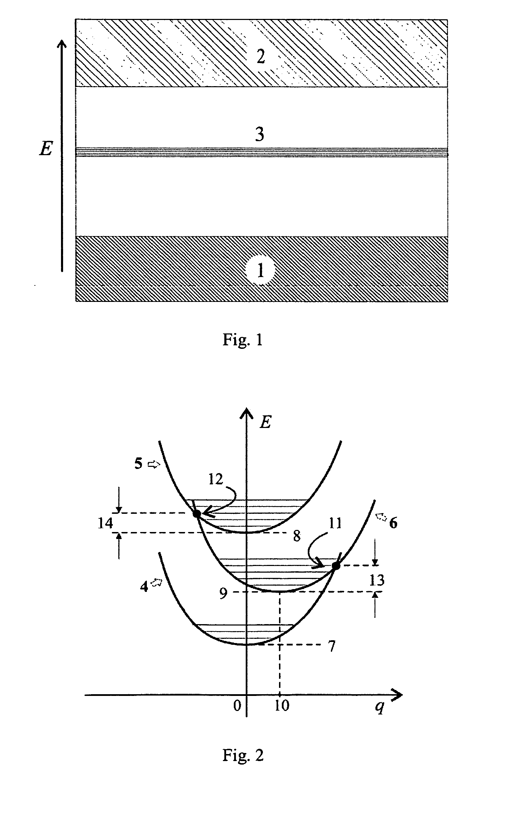

From the former explanation it is clear that the application context of the invention is very wide. Our procedure makes available to the optoelectronic technology a range of new materials with the energetic configuration depicted in Fig. 1 and radiative behavior, through the doping of different semiconductors with diverse deep level centers. In the following, we will present some examples of optoelectronic devices that are presently being fabricated or under development and which could be substituted, or their performance could be improved, by the use of semiconductors doped with deep centers following our procedure.

Several semiconductor devices are developed for the detection of infrared radiation, making use of their capability of absorbing photons through transitions between different electronic states. Some of them are fabricated with low-bandgap semiconductors and exploit the transitions between the valence and conduction bands. Their application is necessarily limited by the existence of a semiconductor with a bandgap energy that matches the radiation range to be detected. There are also designs of radiation detectors based on materials that have been doped to create an impurity band (BIB, blocked impurity band detector, US4568960, US458068, US5457337, etc). They can only be applied to the detection in the far infrared range, since they use shallow level impurities. In this context, the use of materials doped with deep levels enlarges the available absorption range in devices of similar characteristics. This is only possible if the non-radiative recombination is suppressed, in which case photogenerated carriers can have a lifetime large enough to contribute to the signal.

On the other hand, the limitation in the range of wavelengths that are detectable by infrared sensors has already been tackled in recent times by means of the technology of low-dimensional structures. Not only in this context, but in many fields of optoelectronics, quantum wells, wires and dots are nowadays implemented. They make electronic transitions in a wide energy range possible thanks to their confined levels. The introduction of deep levels with suppressed non-radiative recombination following our procedure constitutes an alternative to nanotechnology. Furthermore, it can be more suitable for some applications, because it does not suffer from some of the limitations of that technology. At this respect, infrared detectors using quantum wells (see for instance patents US6657195 or US6642537) do not allow normal incident absorption. Besides, they do not have a null density of states between the band and the confined states from which electronic transitions take place, which leads to short carrier lifetimes. These two important limitations are not present in our invention. On the other hand, detectors using quantum dots instead of quantum wells (US6452242, US0017176, etc) share these advantages with our invention, but they show other drawbacks, as the fact that if their size is increased in order to make them absorb light at shorter wavelengths, more than one confined energy level arises. This compromises again the application to certain energy ranges in an efficient and selective way. It can be mentioned also that there are still problems related to their growth (strain accumulation and formation of dislocations or other defects at interface between dot and barrier material). This restricts the maximum material thickness that can be grown without losing device performance. A deep level doped material on the contrary is not a heterostructure, but a bulk semiconductor, and it is therefore less susceptible to that kind of problems. In this context, the kind of material that is being patented is particularly attractive as an alternative to quantum dot materials for the fabrication of infrared photodetectors following patent P200501296.

In another field of optoelectronics, that of lasers and LEDs, there is also an interest in widening the wavelength range of light emission and here gain we find a possible application of deep level doped materials (with the premise of a radiative behavior) as an alternative to low dimensional structures. In this context our invention shows the same advantages that we have cited for detectors.

To conclude we would like to mention the intermediate band solar cell (WO 00/77829) as a device that will profit from the possibility of implementing an energy band of radiative behavior within a semiconductor's bandgap. This device provides a more efficient use of the solar spectrum than conventional solar cells because it is able to absorb photons of different energy ranges through different electronic transitions simultaneously. We will talk about it in more detail in the *Industrial Applications* section.

### Detailed Description of the Invention

To understand how our invention prevents the non-radiative recombination associated to deep levels, it is necessary to describe the nature of the multiphonon emission process, which is responsible of the recombination. That requires a brief review of some background concepts.

#### Fundamentals

For the analysis of the microscopic dynamics of solids, advantage is taken of the big difference in mass, and consequently in velocity, between electrons and nuclei. First, a Schrödinger equation associated to the fast electrons is solved in which the positions of the nuclei are taken as parameters that provide the external potential. Once this is done, the electronic energy obtained is introduced into the total Hamiltonian leading to a purely nuclear equation in which the electronic energy appears thus completing the potential energy of the nuclei.

The difference between the aforementioned treatment (adiabatic formulation) and the non-approximated Hamiltonian leads to a non-adiabatic term which may be treated as a perturbation that induces transitions from state to state, where the states are those defined in the adiabatic framework.

For the solution of the fast electronic Schrödinger equation, the multi-electronic eigenvectors are split into a set of one-electron eigenvectors (Slater determinants) and a self-consistent calculation is undertaken using one-electron Hamiltonians in which the influence of the other electrons appears as Coulomb repulsion and exchange terms. Every one-electron wavefunction is expressed as a linear combination of previously-selected base functions. The obtained solutions for the one-electron eigenvectors correspond to a given set of nuclei positions. Then we must move the nuclei positions until a lattice-relaxed minimum energy is achieved for the total nuclei-plus-electrons system, which corresponds to the situation of relaxed lattice.

In the preceding calculation not all the one-electron eigenstates (as many as base functions) are filled with electrons, but only some of them, up to the number of total electrons in the crystal. Only the filled states participate in the Coulomb repulsion and the exchange terms. Selecting them to get the lowest energy is the choice that corresponds to the calculation of the fundamental state.

In materials with some impurity, the impurity produces a potential that is different from those of the "pure" species and provides special base functions different from those of the pure atoms (if the base is made up of localized functions, rather than of a plane waves set). For certain impurities one or several energy eigenvalues will appear in the middle of the gap and their eigenfunctions will have a strong projection on the base functions provided by the impurity.

Deep-level impurities, with eigenvalues in the midgap, will produce eigenfunctions which are strongly localized and that may be empty and then filled (or vice-versa) during the recombination process.

Configuration Diagrams

The electronic energy (of all the electrons) for unrelaxed lattice situations becomes a part of the potential energy of the nuclei necessary to study the lattice dynamics. The nuclear energy is usually combined with the electronic energy to draw the so-called "combined potential energy" configuration diagrams. The deviation of the nuclei with respect to their equilibrium position can be expanded to the second order leading to a quadratic form of the combined potential energy of the type $U = \sum_{i,j} b_{ij} \delta R_i \delta R_j$ . This expression can be represented as a two-dimensional plot if, for example, we set a value for all the $\delta R_i$ save one. However, the most illustrative of these two-dimensional plots are those representing the potential energy along a line of maximum slope parameterized by q (the length of the line in the multidimensional $\delta R_i$ space).

In the configuration diagrams the electronic energy usually refers to a single electron while the nuclear energy is associated to the whole crystal. We can divide the latter by the number of electrons to account for homogeneous concepts.

An example of a configuration diagram is represented in Fig. 2. Let us consider, for the moment, the branches in the figure associated to the valence band (4) and the conduction band (5). For them, in the position of equilibrium (q = 0), the energy corresponds to the top of the valence band and the bottom of the conduction band. For other values of $q$, the branches represent the combined potential energy (of electrons and nuclei referred to one electron) as described above and, by definition, the curve for the conduction band is just a vertical displacement of the curve for the valence band. Straight lines (from left to right) are lines of total energy including the nuclei kinetic energy plus the potential energy.

Let us consider now one impurity with at least one deep-level state which is empty. Let us assume that we fill this virtual deep level state with one electron. We call this electron a *trapped* electron. The new band calculation is now the one for an impurity excited state. Now the Coulomb repulsion and exchange terms have a localized component that is different from those in the fundamental state and the relaxed position of the impurity atom once it is charged is different from the previous one. For the rest, some changes may also occur, particularly for the neighbouring ones but, obviously, most of the atoms in the lattice remain unchanged.

Let us also draw in Fig. 2 the configuration diagram (6) along the line of maximum slope joining the old equilibrium position $q_0 = 0$ to the new one $q_1 \neq 0$ (10) for the filled trap. This includes the electronic energy of the filled trap at the new relaxation position $q_1$ plus the total potential energy (per electron) $U$. Indeed the $U$-curve shape may have changed with respect to those for the empty trap used for the valence band and the conduction band. However, beyond the displacement we have just described, this change must be small because the number of unmodified electrons is very large. In other words, the $b_{ij}$ coefficients can sometimes be considered unchanged.

It is also useful to plot in Fig. 2 the valence band and conduction band combined potential energies (per electron) as a function of the impurity displacement (along the maximum slope line) with the trap empty and the same function for the trap once it is filled. This is because, in the subsequent analysis, transitions will occur from band states calculated when the trap is empty to states in the trap once it is filled and from filled trap states to states in the band once the trap is emptied. In summary, we are interested in the configuration diagram for the bands when the trap is empty and for the trap when it is filled.

The Lattice Relaxation MPE Non-Radiative Recombination Mechanism

For the explanation of non-radiative recombination by multiphonon emission or MPE mechanism we refer again to Fig. 2. Note that curve (6), corresponding to the trap-full deep-level, crosses curve (5), corresponding to the conduction band when the trap is empty, at point (12). By the non-adiabatic perturbation, transitions are induced between the thermally excited states of electrons in the conduction band (it can be the electron, the lattice or both that are excited) to the trap-filled deep level near point. The electron capture section of the Shockley Read Hall (SRH) statistics has a temperature dependence of the type exp($-W_n/kT$), where k represents the Boltzmann constant and $W_n$ (14) is the energy difference between point (12) and the conduction band minimum (8).

Once the electron is captured in the trap it remains there, but the energy lost in the electronic state is largely devoted to keeping the impurity in a violent vibrational state -a *breathing* mode- much stronger than the usual thermal oscillations of the lattice atoms. This strong vibrational state would last forever if the lattice was isolated but, in fact, it is subsequently dissipated by interaction with the electrons in the bands that absorb and emit phonons in the usual way (through the non-adiabatic perturbation) for reestablishing the thermal equilibrium so that, in balance, some few tens of phonons (the Huang-Rhys factor) are emitted after the capture process. This gives its name to the MPE recombination process.

The hole capture is the process by which the filled trap releases its electron to an (unoccupied) valence band eigenfunction. For it, the electron in the trap has to be thermally excited, now essentially by impurity vibrations, until it reaches the neighborhood of the energy of point (11) in Fig. 2. Once the transition is produced, the energy lost by the electronic state is mostly used in a new breathing mode (now around $q_0 = 0$) and subsequently dissipated in the aforementioned way. Here the hole capture section is proportional to exp($-W_p/kT$), where $W_p$ (13) is the analogous for holes of $W_n$.

If we summarize the conditions for the MPE mechanism to appear, we must attribute the highest weight to the fact that certain deep level impurities have a state that is sometimes empty but that can become filled. When this occurs, the new charge distribution in the crystal is such that the impurity is displaced from its equilibrium position. In a configuration diagram this is revealed by the fact that the branch of combined potential energy (per electron) of the impurity that presents its minimum out of the fundamental-state equilibrium position. The relaxation to the new position emits enough phonons to balance the electronic energy decrease associated to trapping. In the same way, the return to the equilibrium position when the electron is released to the valence band, it emits enough phonons to balance the reduction of energy when the electron occupies its final fundamental state position in the valence band.

Mott's Transition

Let us consider an array of atoms of a certain impurity located in a crystalline-semiconductor host material. We consider for the moment this material as providing an external field for the impurity Hamiltonian. The latter will be the sum of a number of single-impurity Hamiltonians $H_0^{(n)}$ all embedded in the semiconductor material. We shall consider a basis made up of the normalized functions $|m\rangle$ (one per impurity) that are eigenvectors of the single impurity Hamiltonians of the same eigenvalue $E_0$. These wavefunctions correspond to the trap state we have been considering in the preceding sections. As they correspond to different Hamiltonians they are not strictly orthogonal but if their overlap integral is small they are nearly so.

Neglecting, for the moment, the impurities' electron-electron interaction, the Schrödinger equation for this array is,

$$H\left|\zeta\right\rangle = \sum_n H^{(n)} \sum_m c_m |m\rangle = E \sum_m c_m |m\rangle \qquad (1)$$

which has so many eigenvalues as the number of base functions, that is, the number of impurities. However, if the impurities are sparse enough so that the overlap integrals are zero then there is a single multiple-degenerate eigenvalue of value $E_0$, which multiplicity is the number of impurities. In this case the eigenvectors are the localized functions $|m\rangle$ but also any linear combination of these functions that in this case, may represent an electric charge extended along the whole crystal.

As already said, the aforementioned arguments neglect the electron-electron interaction. However, even if we assume that the host semiconductor is providing an external field for the impurity wavefunctions, so that its electrons are not affected by the impurity electrons, these electrons will still interact among themselves. In consequence many-electron eigenvectors should be considered and treated as described in *Fundamentals.*

However, even if this treatment is not undertaken, when the electron-electron interaction is taken into account, if delocalized functions were accepted as valid solutions, their corresponding eigenvalues would be characterized by higher energies than the localized ones. This is because the overlap between the wavefunctions that exist in the delocalized case causes a positive contribution to the energy as a result of Coulomb interaction. The localized case is, thus, a better solution since it leads to lower energies.

Nevertheless, the eigenfunctions will delocalize when the density of impurities increases. In this we shall follow the original argumentation by Mott. This argument has been used in numerous cases and, in particular, to determine when donor impurity bands become conductive. To our knowledge, it has not been used, not even in its more evolved forms, to determine when deep centre bands become conductive or, what is equivalent, when their electrons become delocalized.

The basis of the argument is as follows: when the electron is taken out of the impurity (or atom, in the general argumentation), it becomes positively charged with an electric charge e that tends to attract the electron with a potential energy $- e^2 /4\pi\varepsilon_0 r$ (SI units). This hydrogen-like potential energy presents bound states as well as unbound states, according to well-known formulas. However the presence of a gas of (potentially) mobile electrons screens the potential.

This is expressed by a potential of the form $-e^2 \exp(-\lambda r)/4\pi\varepsilon_0 r$, where the parameter $\lambda$ increases with the mobile electron density. If $\lambda$ is high enough -approximately the inverse of the Bohr radius-the attracting potential ceases to be able to bound electrons. In this case the electrons become unbound and a transition to delocalized electrons is produced.

Let us apply this general principle to our deep centre electrons. The presence of the host semiconductor electrons introduces a dielectric constant $\varepsilon$ which accounts for the effect caused by the impurity electron in the host material electrons (which so far has been considered as an external potential and therefore not affected by the impurity electron). As a consequence the potential energy takes the form $-e^2/4\pi\varepsilon\varepsilon_0 r$. Unlike metals, the host semiconductor, with a full valence band and an empty conduction band and not having any sensible residual conductivity, produces no screening of the potential energy. However, the impurity electrons $|n\rangle$ produce a certain screening with

$$\lambda^2 = \frac{e^2}{\varepsilon\varepsilon_0}\int\left(-\frac{df(E)}{dE}\right)g(E)\,dE = \frac{e^2}{\varepsilon\varepsilon_0}\int\frac{f(1-f)}{kT}g(E)\,dE \qquad (2)$$

where $f$ is the occupation Fermi-Dirac function and $g(E)$ is the intermediate band density of states per unity of energy and volume. Since the intermediate band is very narrow, and because of the assumed high trap density, it is usually crossed by the IB Fermi level, so we can write $f \cong (1-f) \cong 1/2$. Thus, expression (2) becomes

$$\lambda^2 \cong \frac{e^2}{\varepsilon\varepsilon_0}\int\frac{g(E)}{4kT}\,dE \cong \frac{e^2 N_T}{2\varepsilon\varepsilon_0 kT} \qquad (3)$$

Note that the density of states resulting from the spin is twice the number of traps.

The condition for not retaining bound electrons in the impurity is approximately achieved for $\lambda a_H \cong 0.888$, $a_H = 4\pi\varepsilon\varepsilon_0\hbar^2/m_0 e^2$, being $a_H$ the Bohr radius (no effective mass is used here because the electrons concerned do not move in a band). By substituting in (3) we obtain a critical $N_T = N_{Tcrit} = (1.577 kT\varepsilon\varepsilon_0/e^2 a_H^2)$ which in our case results in $N_{Tcrit} = 5.9\times 10^{-3} cm^{-3}$ for ambient temperature ($kT = 0.025$ eV). This is the impurity density above which the electrons become delocalized due to the electron-electron interaction.

This value has to be considered as indicative. It is based in a rather rough model. Our invention is not associated to the model itself but to the physics principle underlying it.

Note also that no argument here is related to the regular placement of the impurity atoms that, in the Mott scheme, is not expected to affect the delocalization of the electrons and, consequently, the suppression of the MPE recombination, significantly.

The suppression of the MPE-SRH recombination

In the former sections we have reviewed the physical nature of the SRH recombination mechanism. It is based on the displacement of the impurity atom when it captures an electron arising from the electric charge carried by this electron. The relaxation of this displacement provides the phonons necessary to compensate for the variations in electronic energy.

Our procedure of suppressing the recombination mechanism is based on the argumentation exposed. It consists in increasing the density of impurities to such a level that the trapped electron charge density is distributed among all the impurities, preventing the appearance of strong localized charge variations, the consequent displacement of trapping impurities and therefore, the emission of multiple phonons able to balance the change in electronic energy.

Arguments associated to the Mott transition establish that concentrations of $5.9\times 10^{19}$ cm$^{-3}$ for the example examined would suffice to suppress this recombination, without sensible influence of the regularity in their position.

**Brief Description of the Drawings**

FIG. 1 represents the energy band diagram of a material obtained according to our procedure, in which (1) is the valence band, (2) is the conduction band and (3) represents a set of intermediate levels caused by impurities which concentration is sufficient to induce the Mott's transition on the wavefunctions associated to the impurities. In consequence, the levels form an intermediate band free of non-radiative recombination as described in this patent.

FIG. 2 represents a combined potential energy configuration diagram showing the branches of combined potential energy of the valence band top electron (4) and of the conduction band bottom electron (5) when the trap is empty and the one corresponding to the trap when it is filled (6).

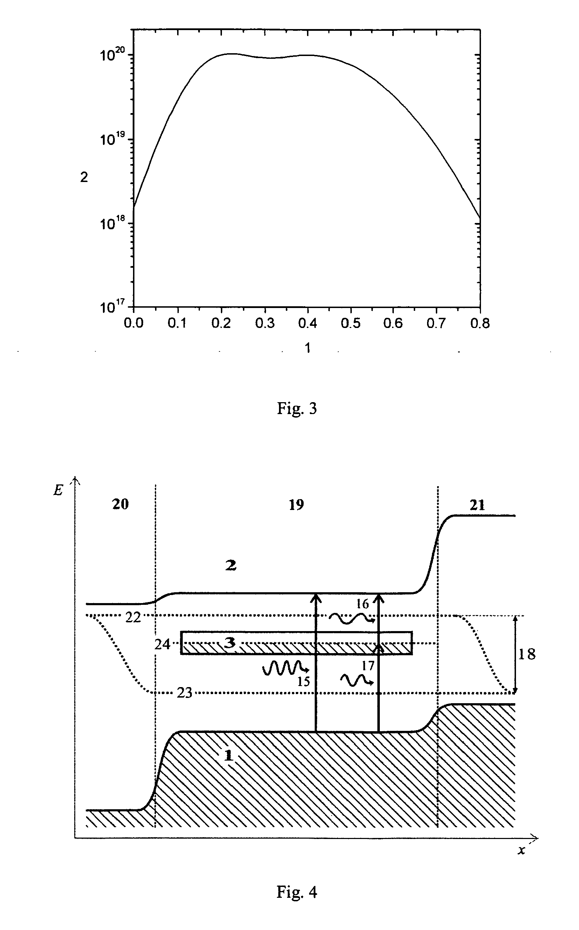

FIG. 3 shows the Ti atoms concentration profile that results from the ion implantation process into a GaAs substrate as described in the text (on the axes, (1) is the depth in $\mu$m and (2) is the concentration of Ti atoms in $cm^{-3}$)

FIG. 4 represents the energy band diagram of an intermediate band solar cell, showing the pumping of electrons from the valence band to the conduction band (15), from the valence band to the intermediate band (17) and from the latter to the conduction band (16). All three processes are produced by the absorption of a photon with the energy appropriate for each case.

## Details of Preferred Embodiments

The manufacture of this IB material can be realized by a variety of methods. One of these methods is ion implantation.
Differently to existing ionic implantation procedures, in our invention, a) the type of elements used in the implantation would be considered, prior to this invention, as inducers of non-radiative recombination and therefore their insertion in the semiconductor bulk material would be prevented with the exception, maybe, of those applications in which an enhancement in the device speed would be pursued as explained in the prior state of the art section b) also prior to this invention, their dose is usually small, but in this invention, the dose should be above of $5.9 \times 10^{19}$ $cm^{-3}$
The process to create a 0.3 $\mu$m thick layer of intermediate band material would be as follows:

a) A gallium arsenide substrate wafer with a silicon nitride cap layer - to prevent the loss of both arsenic and gallium during at the annealing stage - is placed as target in the ionic implanter.

b) Substrate is heated up to 250 C for implanting in order to keep the percent of residual disorder after the implantation below 5 %.

c) Ti ions are implanted on the wafer at 1 MeV at a dose of $3.3 \times 10^{15} cm^{-2}$. This produces an approximated Gaussian profile of Ti atoms implanted in the wafer characterized by a mean value of 0.4 $\mu$m and 0.13 $\mu$m of straggle. The Ti concentration at the mean value results in $10^{20}$ $cm^{-3}$.

d) A second titanium implantation is carried out at 400 keV with at a dose of $1.1 \times 10^{15}$ $cm^{-2}$. This introduces into the wafer an approximated profile of titanium atoms characterized by a mean value of 0.2 $\mu$m and a straggle of 0.066 $\mu$m. The total resulting profile is plotted in Fig. 3.

e) The wafer is annealed at 1000 C for 30 min to reduce the residual disorder and favor the homogenization of the distribution of titanium. The cap layer prevents the arsenic loss. Then the wafer is slowly cooled.

f) The first 0.1 $\mu$m of the wafer, containing also the cap layer, are removed by dry etch.

## Industrial Application

Different possible applications of this invention have already been introduced as the prior state of the art was exposed (infrared radiation detectors, lasers and LEDs). In this section we are going to focus on a particular application, the intermediate band solar cell (IBSC) (European Patent EP 1 130 657 A2 P9901278 (2001), US Patent 6444897B1 (2002)). The band diagram of this device is showed in Fig. 4. A material (19) with a half-filled (or *metallic*) intermediate band (3) near the centre of the semiconductor forbidden gap, may lead to higher PV conversion efficiencies through a better use of the solar spectrum.
In such a material, in addition to the conventional promotion (15) of electrons from the valence (1) to the conduction band (2) by absorption of a high energy photon, it is also possible the promotion (17) of electrons from the valence band to the empty states in the intermediate band (10), or from the full states of this band to the conduction band (16). In summary, photons of three energy ranges are absorbed in such a way that the energy loss in the subsequent thermalization of the electrons is small. Furthermore, their energy (of the single high energy photon or of the couple of low energy photons) can be fully recovered to a value close to $E_G$. To achieve this, the material must be sandwiched between two layers of ordinary semiconductor with a bandgap similar to $E_G$ (20, 21). In this way the Fermi level splits into three quasi-Fermi levels (22, 23, 24), but only the two extreme quasi-Fermi levels - the one associated to the conduction band (22) and the one associated to valence band (23) - are externally connected, which allows the output voltage to approach $E_G$ / e. The theoretical potential of this concept is 63%.

**Claims**

1. A method for suppressing non-radiative recombination in semiconductors with intermediate levels due to impurities consisting of increasing the concentration of such impurities to a point at which the wavefunctions representing the trapped states become delocalized and they are shared among many impurities in the semiconductor.

2. A method according to claim 1, **characterized in that** the concentration of impurities is achieved by ionic implantation, by diffusion of the impurities into the semiconductor material or by chemical or physical deposition of an epitaxial crystal of a suitable composition containing the impurities.

3. A method according to claims 1 or 2, **characterized in that** the redistribution of the impurities is assisted by thermal annealing.

4. A method according to claims 1 to 3, **characterized in that** the semiconductor belongs to group III-V or II-VI and the impurities are any chalcogenide or any transition element.

5. A method according to claims 1 to 4, **characterized in that** the density of impurities is increased to over $5.9 \times 10^{19}$ cm$^{-3}$.

6. A material (intermediate band material) manufactured according to the method described in claims 1 to 5, **characterized by** the existence of an electronic band (intermediate band) isolated from the conduction and valence bands through a null density of states.

7. A material manufactured according to the method described in claims 1 to 5, **characterized by** having intermediate levels.

8. A material according to claims 6 or 7, **characterized in that** the intermediate band or the intermediate levels originate from a chemical compound or an alloy where the species of lower concentration have a density above the density deduced from claim 1 or indicated in claim 5.

9. Use of the method according to claims 1 to 5 and of one or more of the intermediate band materials or materials with intermediate levels according to claims 6 to 8 for the manufacture of solar cells, photodetectors, LEDs, lasers and any other electrical or optoelectronic device.

Fig. 1

Fig. 2

Fig. 3

Fig. 4

## INTERNATIONAL SEARCH REPORT

| International application No. |
| --- |
| PCT/ ES 2006/000683 |

**A. CLASSIFICATION OF SUBJECT MATTER**

see extra sheet

According to International Patent Classification (IPC) or to both national classification and IPC

**B. FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CIBEPAT,EPODOC, WPI, IEEE

**C. DOCUMENTS CONSIDERED TO BE RELEVANT**

| Category* | Citation of document, with indication, where appropriate, of the relevant passages | Relevant to claim No. |
| --- | --- | --- |
| A | M.J. KEEVERS, M.A. GREEN. Efficiency improvements of silicon solar cells by the impurity photovoltaic effect. Journal of Applied Physics (1994) Vol. 75, N°8, pages 4022-4031, ISSN 0021-8979. | 1-9 |
| A | A. LUQUE, A. MARTI. Increasing the Efficiency of Ideal Solar Cells by Photon Induced Transitions at Intermediate Levels. Physical review letters (1997) Vol.78, N° 26, pages 5014-5017, ISSN 0031-9007. | 1-9 |

☐ Further documents are listed in the continuation of Box C.　　　☐ See patent family annex.

| | | |
| --- | --- | --- |
| * Special categories of cited documents: | "T" | later document published after the international filing date or priority date and not in conflict with the application but cited to understand the principle or theory underlying the invention |
| "A" document defining the general state of the art which is not considered to be of particular relevance. | | |
| "E" earlier document but published on or after the international filing date | | |
| "L" document which may throw doubts on priority claim(s) or which is cited to establish the publication date of another citation or other special reason (as specified) | "X" | document of particular relevance; the claimed invention cannot be considered novel or cannot be considered to involve an inventive step when the document is taken alone |
| "O" document referring to an oral disclosure use, exhibition, or other means | "Y" | document of particular relevance; the claimed invention cannot be considered to involve an inventive step when the document is combined with one or more other documents , such combination being obvious to a person skilled in the art |
| "P" document published prior to the international filing date but later than the priority date claimed | | |
| | "&" | document member of the same patent family |

| Date of the actual completion of the international search | Date of mailing of the international search report |
| --- | --- |
| 23 March 2007　　(23.03.2007) | (12/04/2007) |
| Name and mailing address of the ISA/ O.E.P.M. Paseo de la Castellana, 75 28071 Madrid, España. Facsimile No.　34 91 3495304 | Authorized officer J. A. Peces Aguado Telephone No. +34 913496870 |

## INTERNATIONAL SEARCH REPORT

International application No.

PCT/ ES 2006/000683

CLASSIFICATION OF SUBJECT MATTER

*H01L 31/06* (2006.01)
*H01L 31/08* (2006.01)
*H01L 31/0352* (2006.01)
*H01L 31/0296* (2006.01)
*H01L 31/0304* (2006.01)

Form PCT/ISA/210 (extra sheeet) (April 2005)

**EP 1 978 565 A1**

**REFERENCES CITED IN THE DESCRIPTION**

**Patent documents cited in the description**

- US 4568960 A
- US 458068 A
- US 5457337 A
- US 6657195 B
- US 6642537 B
- US 6452242 B
- US 0017176 A
- WO 0077829 A
- EP 1130657 A2
- EP P9901278 A
- US 6444897 B1